# EUROPEAN PATENT APPLICATION

(11) **EP 1 739 741 A2**
(43) Date of publication of application: **03.01.2007**
(21) Application number: 06076225.9
(22) Date of filing: 14.06.2006
(51) Int. Cl.: H01L 23/367, H01L 23/492

(54) **Electronic assembly with backplate having at least one thermal insert**

(30) Priority: 30.06.2005 US 172357
(71) Applicant: Delphi Technologies, Inc., Troy, Michigan 48007 (US)
(72) Inventor: Brandenburg, Scott D., Kokomo, IN 46902 (US); Degenkolb, Thomas A., Noblesville, IN 46060 (US)
(74) Representative: Denton, Michael John

(57) **Abstract**

A technique for manufacturing an electronic assembly includes a number of steps. Initially, a backplate with a cavity formed into a first side of the backplate is provided. Next, an insert is inserted within the cavity. Then, a substrate, with a first side of an integrated circuit (IC) die mounted to a first side of the substrate, is provided. The IC die is electrically connected to one or more of a plurality of electrically conductive traces formed on the first side of the substrate. The first side of the substrate is positioned in contact with the first side of the backplate and a second side of the IC die is soldered to the second side of the IC die.

## Description

### TECHNICAL FIELD

The present invention is generally directed to an electronic assembly and, more specifically, to an electronic assembly with a backplate having at least one thermal insert.

### BACKGROUND OF THE INVENTION

Traditionally, electronic assemblies utilized in an automotive environment have utilized a number of different techniques to remove excessive heat from high-power integrated circuit (IC) dies. Traditionally, the ICs, which have been electrically connected to a substrate, have been heatsinked to a metal backplate. The thermal performance of the heatsink-IC die interface has been improved through a number of techniques, e.g., by using a thermal grease, a thermal film or soldering a non-active side of the die to the heatsink.

An advantage of thermally connecting the IC die to the heatsink with a solder is that solder generally has a very high bulk conductivity and practically no interfacial resistance, as it creates a bond with the backside of the flip-chip and the heatsink. However, one problem with using a solder as a thermal interface material is that solder requires a solderable interface for bonding. Today, the majority of heatsink backplates implemented in electronic assemblies in the automotive environment are aluminum, which is used primarily due to the fact that it is relatively inexpensive, can be cast-molded and is relatively light-weight. Unfortunately, aluminum does not offer a solderable surface.

As an alternative to aluminum, some manufacturers have proposed implementing a copper or plated copper backplate. Unfortunately, a plated copper backplate may be approximately five times as costly as that of an aluminum backplate and, in general, weighs at least twice as much as a same-sized aluminum backplate. Although copper stamping could be utilized to create the backplate, such a backplate would still be at least two times the cost of an aluminum backplate. Furthermore, copper is difficult to machine and cannot be formed from a casting. Thus, the cost and weight disadvantages of a copper backplate make the utilization of solder as a thermal interface material substantially less attractive.

What is needed is an economical electronic assembly that provides for improved thermal performance of high-power integrated circuits (ICs) of the assembly.

### SUMMARY OF THE INVENTION

A technique for manufacturing an electronic assembly, according to one aspect of the present invention, includes a number of steps. Initially, a backplate that includes a cavity is provided. Next, an insert, which functions as a heatsink and includes at least an outer surface that is made of copper, is inserted within the cavity. Then, a substrate, with a first side of an integrated circuit (IC) die mounted to a first side of the substrate, is provided. The IC die is electrically connected to one or more of a plurality of electrically conductive traces formed on the first side of the substrate. The first side of the substrate is then positioned in contact with at least a portion of the first side of the backplate. A second side of the IC die is positioned in thermal contact with the heatsink and a solder is utilized to provide a thermally conductive interface, between at least a portion of the second side of the IC die and the heatsink.

According to another aspect of the present invention, the substrate and at least a portion of the backplate are overmolded with an overmold material. In this embodiment, the overmold material substantially underfills the IC die and bonds the insert to the backplate. According to a different aspect of the present invention, the substrate is a printed circuit board (PCB). According to another embodiment of the present invention, the solder is an Indium-based solder. According to another aspect of the present invention, the IC die may be a flip-chip. According to a different aspect of the present invention, the backplate is made of aluminum. According to another embodiment, an adhesive is positioned between at least a portion of the first side of the substrate and the first side of the backplate. The insert may be electrically isolated from the backplate. In one or more embodiments, the cavity is formed as a through-hole and the insert may have a cylindrical shape.

These and other features, advantages and objects of the present invention will be further understood and appreciated by those skilled in the art by reference to the following specification, claims and appended drawings.

### BRIEF DESCRIPTION OF THE DRAWINGS

The present invention will now be described, by way of example, with reference to the accompanying drawings, in which:
Fig. 1 is a top perspective view of a backplate, constructed according to one embodiment of the present invention, for an electronic assembly;
Fig. 1A is a cross-sectional view of a relevant portion of a backplate constructed according to one embodiment of the present invention;
Fig. 1B is a cross-sectional view of a relevant portion of a backplate configured according to another embodiment of the present invention;
Fig. 1C is a cross-sectional view of a relevant portion of a backplate configured according to yet another embodiment of the present invention;
Fig. 2 is a cross-sectional view of a relevant portion of an overmolded electronic assembly constructed according to one embodiment of the present invention; and
Fig. 3 is a flow chart of an exemplary process for manufacturing the assembly of Fig. 2.

### DESCRIPTION OF THE PREFERRED EMBODIMENTS

An electronic assembly constructed according to various embodiments of the present invention provides a relatively low-cost assembly with a solderable heatsink that provides a relatively efficient thermal heat dissipation structure for high-power integrated circuit (IC) dies, such as flip-chips. In a majority of electronic products, a small number of IC dies typically consume the majority of the power required for the products. As noted above, one technique to increase the dissipation of waste energy in IC dies is to solder a non-active backside of the die to a metal heatsinking backplate. According to one embodiment of the present invention, as a solderable area is only required in flip-chip areas, plated metal heatsinks or inserts, e.g., metal cylinders, are inserted into a relatively low-cost backplate, e.g., an aluminum backplate. Alternatively, a low-cost plastic backplate may also be used, assuming that the metal pedestals are in contact with a cold plate. The solderable surfaces of the insert facilitate the use of very high-thermal conductive solders, such as Indium, which has an 86W/mK conductivity, as a thermal interface material between a flip-chip and its associated heatsink. Due to the fact that an intermetallic joint is formed between the flip-chip and the heatsink, thermal resistance, at the joint interface, is substantially zero.

According to one embodiment of the present invention, metal inserts are manufactured from a round metal stock that has been cut to a desired length. The end surfaces of the cut round metal stock are then machined to a specified surface finish. A solderable coating is then applied to at least the end surfaces of the cut round metal stock. The coating may be, for example, an electroless nickel/gold plating, a tin/copper/zinc plating or other suitable plating material. The plated inserts are then pressed into cavities, e.g., through-holes or pockets, in a backplate, which may be made from aluminum. The holes may be formed during the casting process or may be formed by machining. It should be appreciated that, when implemented within an overmolded product, the overmold compound can form a seal and help bond the insert to the backplate.

In applications in which a backside of an IC die is required to be electrically insulated from a metal backplate, an electrically insulating thermally conductive jacket may be attached to or formed on an external surface of the insert, prior to installation in the backplate. When the insert is a copper cylinder, or a plated copper cylinder, the insert provides good thermal conductivity, as the thermal contact surface area of the copper cylinder to the backplate is relatively large, i.e., the cylinder circumference times the height of the cylinder in contact with the backplate. It should also be appreciated that waste energy may also be conducted through the ends (Z-axis) of the insert. The jacket may be, for example, a ceramic-filled plastic or other thermally conductive electrically insulating material.

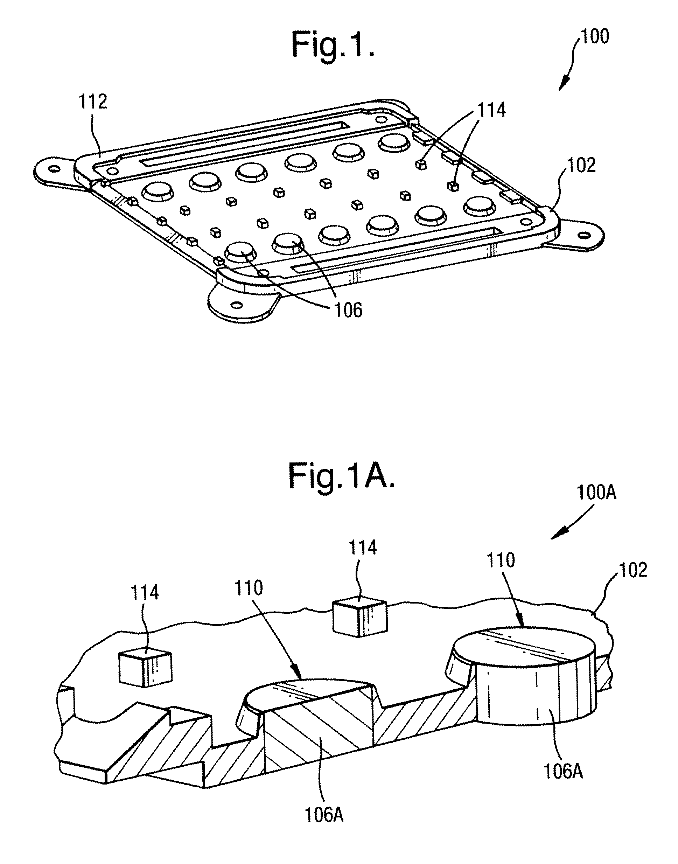

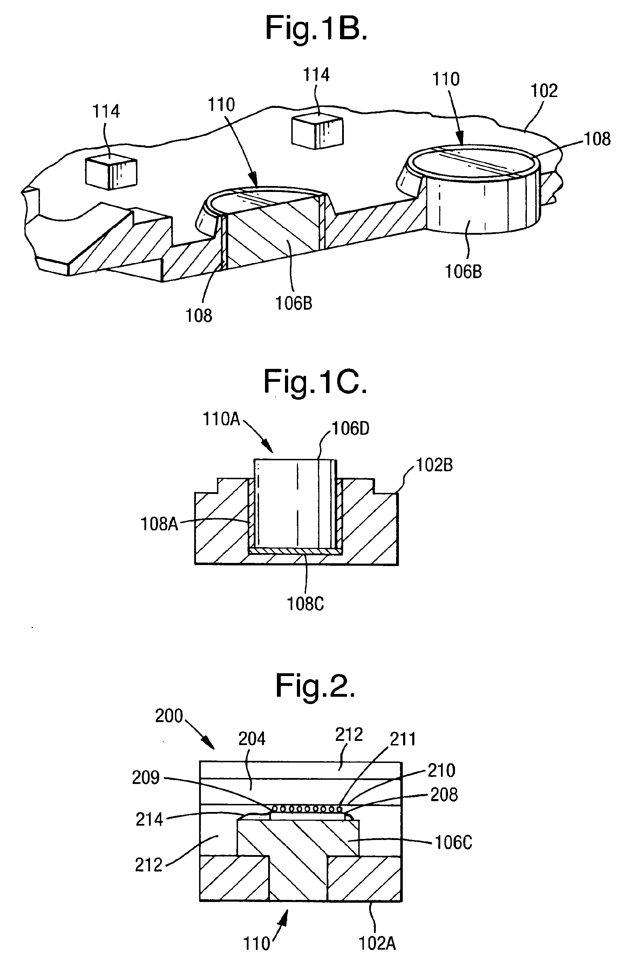

With reference to Fig. 1, a backplate 100 is depicted that includes a peripheral lip 112, a plurality of standoffs 114 and a plurality of inserts 106, which are inserted in cavities 110 formed in the backplate 100. The inserts 106 conduct heat away from an associated IC die (not shown in Fig. 1). With reference to Fig. 1A, a relevant portion of a backplate 102, formed according to one embodiment of the present invention, is depicted. As is shown in Fig. 1A, inserts 106A are inserted into cavities, e.g., through-holes, 110 formed in the backplate 102. With reference to Fig. 1B, inserts 106B include an outer non-electrically conductive coating 108, which electrically isolates the inserts 106B from the backplate 102. The inserts 106B may be advantageously implemented in applications for vertical devices that require that a backside of an IC die be electrically insulated from a metal backplate. With reference to Fig. 1C, a copper-plated insert 106D is depicted that includes an outer non-electrically conductive coating 108A (e.g., a boron nitride coating), which electrically isolates an outer surface of the insert 106D from backplate 102B. The insert 106D is positioned within a pocket 110A, formed in the backplate 102B, and an end of the insert 106D is electrically isolated from the backplate 102B by a thermally conductive dielectric material 108C. The insert 106D may also be advantageously implemented in applications for vertical devices that require that a backside of an IC die be electrically insulated from a metal backplate.

Turning to Fig. 2, a relevant portion of an electronic assembly 200 is shown. As is depicted, the insert 106C is installed in a cavity, e.g., a through-hole, 110 formed into the backplate 102A. A solder 214 mechanically and thermally connects a backside of a flip-chip 208 to the insert 106C, which acts as a heatsink. A plurality of solder bumps 210 interconnect electrical contacts 209 of the flip-chip 208 to electrically conductive traces 211, which are formed on a surface of the substrate 204. As is depicted, a molding compound 212 is utilized to seal the assembly 200.

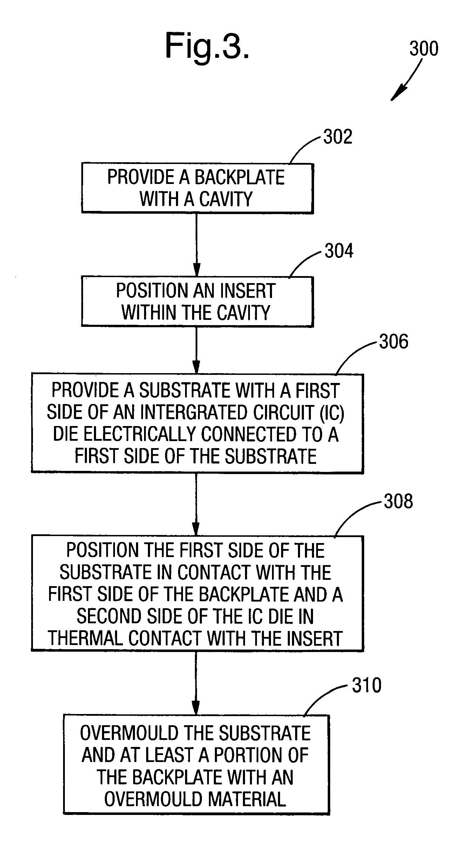

With reference to Fig. 3, a routine 300 for manufacturing an electronic assembly 200 of Fig. 2, according to one aspect of the present invention, is disclosed. In step 302, a backplate 102A with a cavity 110 is provided. Next, in step 304, an insert 106C is positioned in the cavity 110 of the backplate 102A. Next, in step 306, a substrate 204, with a first side of an integrated circuit (IC) die 208 electrically connected to a first side of the substrate 204, is provided. Next, in step 308, the first side of the substrate 204 is positioned in contact with the first side of the backplate 102A and a second side of the IC die 208 is positioned in thermal contact with the insert 106C. Finally, in step 310, the substrate 204 and at least a portion of the backplate 102A are overmolded with an overmold material 212.

Accordingly, an electronic assembly has been described herein that exhibits improved thermal performance, which is facilitated by soldering an end of an insert, which is installed in a backplate, to a non-active side of an integrated circuit (IC) die.

The above description is considered that of the preferred embodiments only. Modifications of the invention will occur to those skilled in the art and to those who make or use the invention. Therefore, it is understood that the embodiments shown in the drawings and described above are merely for illustrative purposes and not intended to limit the scope of the invention, which is defined by the following claims as interpreted according to the principles of patent law, including the doctrine of equivalents.

## Claims

1. A method (300) for manufacturing an electronic assembly, comprising the steps of:
providing a backplate (302), wherein the backplate includes a cavity;
positioning an insert within the cavity (304), wherein the insert functions as a heatsink and at least an outer surface of the insert is made of copper;
providing a substrate with a first side of an integrated circuit (IC) die mounted to a first side of the substrate (306), wherein the IC die is electrically connected to one or more of a plurality of electrically conductive traces formed on the first side of the substrate; and
positioning the first side of the substrate in contact with at least a portion of the first side of the backplate (308), wherein a second side of the IC die is positioned in thermal contact with the heatsink, and wherein a solder provides a thermally conductive interface between at least a portion of the second side of the IC die and the heatsink.

2. The method (300) of claim 1, further comprising the step of:
overmolding the substrate and at least a portion of the backplate with an overmold material (310), wherein the overmold material substantially underfills the IC die and bonds the insert to the backplate.

3. The method (300) of claim 1, wherein the substrate is a printed circuit board (PCB).

4. The method (300) of claim 1, wherein the solder includes Indium.

5. The method (300) of claim 1, wherein the IC die is a flip-chip.

6. The method (300) of claim 1, wherein the backplate is made of aluminum.

7. The method (300) of claim 6, further comprising the step of:
positioning an adhesive between at least a portion of the first side of the substrate and the first side of the backplate.

8. The method (300) of claim 1, wherein the insert is electrically isolated from the backplate.

9. The method (300) of claim 1, wherein the cavity is a through-hole.

10. The method (300) of claim 1, wherein the insert has a cylindrical shape and the backplate is made of aluminum.

11. A method (300) for manufacturing an electronic assembly, comprising the steps of:
providing a backplate (302), wherein the backplate includes a cavity;
positioning an insert within the cavity (304), wherein the insert functions as a heatsink and is made of copper;
providing a substrate with a first side of an integrated circuit (IC) die mounted to a first side of the substrate (306), wherein the IC die is electrically connected to one or more of a plurality of electrically conductive traces formed on the first side of the substrate;
positioning the first side of the substrate in contact with at least a portion of the first side of the backplate (308), wherein a second side of the IC die is positioned in thermal contact with the heatsink, and wherein a solder provides a thermally conductive interface between at least a portion of the second side of the IC die and the heatsink; and
overmolding the substrate and at least a portion of the backplate with an overmold material (310), wherein the overmold material substantially underfills the IC die and bonds the insert to the backplate, and wherein the solder includes Indium.

12. The method (300) of claim 11, wherein the IC die is a flip-chip.

13. The method (300) of claim 12, wherein the backplate is made of aluminum.

14. The method (300) of claim 13, further comprising the step of:
positioning an adhesive between at least a portion of the first side of the substrate and the first side of the backplate.

15. The method (300) of claim 13, wherein the cavity is a through-hole.

16. The method (300) of claim 11, wherein the insert is cylindrically shaped and is electrically isolated from the backplate.

17. An electronic assembly (200), comprising:
a backplate (102A) including a cavity (110);
an insert (106C) positioned within the cavity (110), wherein the insert (106C) functions as a heatsink; and
a substrate (204) with a first side of an integrated circuit (IC) die (208) mounted to a first side of the substrate (204), wherein the IC die (208) is electrically connected to one or more of a plurality of electrically conductive traces formed on the first side of the substrate (204), and wherein the first side of the substrate (204) is positioned in contact with at least a portion of the first side of the backplate (102A), where the IC die (208) is in thermal contact with the backplate (102A) and a second side of the IC die is (208) positioned in thermal contact with the heatsink, and where a solder (214) provides a thermally conductive interface between at least a portion of the second side of the IC die (208) and the heatsink.

18. The assembly (200) of claim 17, further comprising:
an overmold material (212) overmolding the substrate (204) and at least a portion of the backplate (102A), wherein the overmold material (212) substantially underfills the IC die (208).

19. The assembly (200) of claim 17, wherein the substrate (204) is a printed circuit board (PCB) and the IC die (208) is a flip-chip.

20. The assembly (200) of claim 17, wherein the insert (106C) is electrically isolated from the backplate (102A).

21. The assembly (200) of claim 17, wherein the cavity (110) is a through-hole.

22. The assembly (200) of claim 17, wherein the insert (106C) has a cylindrical shape and is made of copper and the backplate (102A) is made of aluminum.
